# EUROPÄISCHE PATENTANMELDUNG

(11) **EP 2 448 030 A1**
(43) Veröffentlichungstag der Anmeldung: **02.05.2012**
(21) Anmeldenummer: 10188793.3
(22) Anmeldetag: 26.10.2010
(51) Int. Cl.: H01L 41/193, H01L 41/26

(54) **Elektromechanischer Wandler mit einem zweischichtigen Basiselement und Verfahren zur Herstellung eines solchen elektromechanischen Wandlers**

(71) Anmelder: Bayer MaterialScience AG, 51368 Leverkusen (DE)
(72) Erfinder: Lovera-Prieto, Dr. Deliani, 6241 CZ Bundde (NL); Reisner, Ernst-Ulrich, 51368 Leverkusen (DE); Jenninger, Dr. Werner, 51368 Leverkusen (DE); Wagner, Dr. Joachim, 51368 Leverkusen (DE)

(57) **Zusammenfassung**

Die vorliegende Erfindung betrifft einen elektromechanischen Wandler mindestens umfassend einen Polymerschichtverbund mit darin ausgebildeten Hohlräumen (5) wobei der Polymerschichtverbund mindestens
- ein Polymerschicht-Basiselement (1) umfassend eine Trägerschicht (1a) mit einer Erweichungstemperatur Tg_{A} und eine mit dieser flächig verbundene Elektretschicht (1b) mit einer Erweichungstemperatur Tg_{E}, wobei Tg_{A} > Tg_{E} ist, und
- ein zweites Polymerschicht-Element (2) umfasst, wobei
das Polymerschicht-Basiselement (1) mit seiner Elektretschicht (1b) mindestens teilweise mit dem zweiten Polymerschicht-Element (2), unter Ausbildung von Hohlräumen (5), verbunden ist. Die Erfindung betrifft weiterhin ein Verfahren zur Herstellung eines elektromechanischen, beispielsweise piezoelektrischen, Wandlers sowie dessen Verwendung.

## Beschreibung

Die vorliegende Erfindung betrifft einen elektromechanischen Wandler mit einem zweischichtigen Polymerschicht-Basiselement und ein Verfahren zu dessen Herstellung. Weiterhin betrifft die Erfindung auch die Verwendung eines solchen elektromechanischen Wandlers.

Elektromechanische Wandler nutzen die Fähigkeit einiger Materialien, ein elektrisches Potential aufgrund einer ausgeübten mechanischen Belastung auszubilden aus. Diese Eigenschaft bezeichnet man als Piezoelektrizität. Etablierte piezoelektrische Materialien sind Blei-Zirkonium-Titanat (PZT) und fluorierte Polymere wie Polyvinylidenfluorid (PVDF). Piezoelektrisches Verhalten wurde auch in geschäumtem, geschlossenporigen Polypropylen (PP) beobachtet. Um Piezoelektrizität zu erreichen, wird ein solcher Polypropylenschaum in einem hohen elektrischen Feld aufgeladen. Dadurch finden innerhalb der Poren elektrische Durchschläge statt, welche Makrodipole generieren und das Material makroskopisch polarisieren. Derartige Polypropylenferroelektrete können einen piezoelektrischen Koeffizienten von einigen Hundert Pikocoulomb pro Newton aufweisen. Um die Sensitivität der Sensorwirkung weiter zu erhöhen, wurden Mehrschichtsysteme aus mehreren übereinander gestapelten Schäumen entwickelt.

Gerhard et al. (2007 Annual Report Conference on Electrical Insulation and Dielectric Phenomena, Seiten 453 bis 456) beschreibt ein Dreischichtferroelektret, in dem ein Polytetrafluorethylenfilm, welcher durch mechanisches oder laserbasiertes Bohren mit einer Vielzahl von gleichförmigen, durchgehenden Aussparungen versehen wurde, zwischen zwei gleichförmigen Fluorethylenpropylenfilmen angeordnet ist.

Eine vorteilhaft einfache Herstellungsmethode für Ferroelektrete mit röhrenförmigen Hohlräumen homogener Größe und Struktur wurde von R. A. P. Altafim, X. Qiu, W. Wirges, R. Gerhard, R. A. C. Altafim, H.C. Basso, W. Jenninger und J. Wagner in dem Artikel "Template-based fluoroethylenepropylene piezoelectrets with tubular channels for transducer applications", akzeptiert zur Publikation im Journal of Applied Physics, beschrieben. Bei dem dort beschriebenen Verfahren wird zunächst eine Sandwichanordnung zweier FEP-Folien (FEP: Perfluorethylenpropylen-Copolymer)und einer dazwischen eingelegten PTFE-Maskenfolie bereitgestellt. Der gebildete Folienstapel wird laminiert, die FEP-Folien miteinander verbunden und nachfolgend die Maskenfolie unter Freigabe der Hohlräume entfernt.

Elektromechanische Wandler, insbesondere piezolektrische Wandler, sind für kommerzielle Anwendungen, beispielsweise für Sensor- und Aktorsysteme, weiterhin von zunehmendem Interesse. Für die Wirtschaftlichkeit ist dabei eine Anwendbarkeit eines Herstellungsverfahrens im industriellen Maßstab essentiell.

Aufgabe der vorliegenden Erfindung ist es daher, Elektromechanische Wandler der eingangs genannten Art anzugeben sowie Verfahren zu deren Herstellung bereitzustellen, die einfach und kostengünstig auch im großtechnischen und industriellen Maßstab durchführbar sind.

Die Aufgabe wird erfindungsgemäß mit einem elektromechanischen Wandler umfassend einen Polymerschichtverbund mit darin ausgebildeten Hohlräumen dadurch gelöst, dass der Polymerschichtverbund mindestens
- ein Polymerschicht-Basiselement umfassend eine Trägerschicht mit einer Erweichungstemperatur Tg_{A} und eine mit dieser flächig verbundene Elektretschicht mit einer Erweichungstemperatur Tg_{E}, wobei die Erweichungstemperatur der Trägerschicht Tg_{A} > Tg_{E} der Erweichungstemperatur der Elektretschicht ist (Tg_{A} > Tg_{E}) und
- ein zweites Polymerschicht-Element
umfasst, und das Polymerschicht-Basiselement mit seiner Elektretschicht mindestens teilweise mit dem zweiten Polymerschicht-Element, unter Ausbildung von Hohlräumen, verbunden ist.

Die erfindungsgemäßen Polymerschichtverbunde weisen mit anderen Worten übereinander geschichtete Polymerfilme, insbesondere Polymerfolien, und mindestens zwischen jeweils zwei Polymerfolien ausgebildete Hohlräume auf. Die Polymerfolien sind dabei zwischen den Hohlräumen miteinander verbunden. Ein wesentlicher Bestandteil der Erfindung ist, dass mindestens das Polymerschicht-Basiselement ein zweischichtiger Polymerverbund aus einer Trägerschicht und einer Elektretschicht ist.

Die Erweichungstemperatur wird auch Glasübergangstemperatur genannt und ist die Temperatur, bei der ein amorphes Polymer vom flüssigen oder gummielastischen, flexiblen Zustand in den glasartigen oder hartelastischen, spröden Zustand übergeht. Erfindungsgemäß umfassen die Angaben und Bereiche zu den Erweichungstemperaturen Tg der Polymerschichten gegebenenfalls jeweils auch die Schmelztemperaturen bei gemischtphasigen Polymerschichten, insbesondere aus teilkristallinen polymeren Materialien.

Das erfindungsgemäße Polymerschicht-Basiselement ist ein zweischichtiger Aufbau aus zwei Polymerschichten, insbesondere Polymerfilmen, aus unterschiedlichen polymeren Materialien, wobei das polymere Material der Elektretschicht eine niedrigere Erweichungstemperatur Tg_{E} aufweist als das polymere Material der Trägerschicht. Das Polymerschicht-Basiselement wird erfindungsgemäß auch als Basiselement bezeichnet. Das Basiselement wird vorzugsweise aus durchgehenden Polymerschichten, insbesondere Polymerfilmen, gebildet. Das Basiselement kann jedoch, beispielsweise in der Elektretschicht, auch Ausnehmungen aufweisen.

Die Trägerschicht übernimmt erfindungsgemäß eine Träger- und Stützfunktion für die Elektretschicht und verleiht dem, gegebenenfalls strukturierten, Basiselement und auch dem resultierenden Polymerschichtverbund mit dem zweiten Polymerschichtelement vorteilhafterweise eine ausreichende mechanische und thermische Stabilität.

Die Elektretschicht ist erfindungsgemäß flächig, beispielsweise ganzflächig, mit der Trägerschicht verbunden und ist erfindungsgemäß aus einem polymeren Material mit guten Ladungsspeichereigenschaften ausgebildet. Durch die Stützfunktion der Trägerschicht kann die Elektretschicht dünner ausgeführt sein als in einer Ausführungsform ohne Trägerschicht.

Es wurde überraschend festgestellt das erfindungsgemäß aufgebaute elektromechanische Wandler neben guten piezoelektrischen Eigenschaften, vorteilhafterweise eine besonders gute Adhäsion zwischen den Polymerschichten und eine besonders gute mechanische Stabilität aufweisen. Die Trägerschichten geben im erfindungsgemäßen Aufbau die notwendige mechanische und thermische Stabilität. Vorteilhafterweise können durch den Einsatz einer Trägerschicht im Verbund auch eher spröde Materialien mit guten Elektreteigenschaften im Polymerschicht-Basiselement zum Aufbau elektromechanischer Wandler eingesetzt werden. Die Elektretschichten können also erfindungsgemäß nach besonders geeigneten Ladungsspeichereigenschaften ausgewählt werden, da die notwendige mechanische Stabilität durch die Trägerschicht erhalten wird. Somit kann auf einfache Weise eine Kombination besonders vorteilhafter Eigenschaften für den erfindungsgemäßen elektromechanischen Wandler erzielt werden.

In einer Ausführungsform der Erfindung können die Materialien für die Polymerschichten in einem erfindungsgemäßen Basis-Polymerschichtelement so gewählt sein, dass die Erweichungstemperatur der Trägerschicht Tg_{A}, mindestens > 5 °C, beispielsweise 10 °C höher ist, als die Erweichungstemperatur der Elektretschicht Tg_{E}. Dies erleichtert die Verbindung des Polymerschicht-Basiselements mit dem zweiten Polymerschicht-Element, insbesondere durch ein Laminierverfahren. Hierbei kann die Elektretschicht vorteilhafterweise gleichzeitig als Klebeschicht dienen, zum anderen kann die Trägerschicht eine ausreichende mechanische Stabilität beibehalten, gegebenenfalls auch die vorhandenen dreidimensionalen Strukturen des Basiselements stützen.

Die Trägerschicht kann erfindungsgemäß grundsätzlich aus Polymeren oder Polymermischungen ausgebildet sein oder solche umfassen, die eine geeignete Verbindung mit der Elektretschicht zulassen und eine ausreichende Trägerfunktion und damit mechanische und thermische Stabilität aufweisen. Beispielsweise kann im Rahmen einer vorteilhaften Ausführungsform der Erfindung die Trägerschicht mindestens ein Polymer, ausgewählt aus der Gruppe bestehend aus Polytetrafluorethylen (PTFE), Polycarbonaten und Mischungen dieser Polymere umfassen oder daraus ausgebildet sein.

Im Rahmen der vorliegenden Erfindung kann eine Elektretschicht grundsätzlich aus jedem Polymer beziehungsweise Polymergemisch ausgebildet sein, welches geeignet ist, Ladungen über einen langen Zeitraum, beispielsweise einige Monate oder Jahre, zu halten. Bevorzugt kann nach der Erfindung eine Elektretschicht mindestens ein Polymer, ausgewählt aus der Gruppe bestehend aus Polycarbonaten, perfluorierten oder teilfluorierten Polymeren und Co-Polymeren, wie Polytetrafluorethylen (PTFE), Fluorethylenpropylen (FEP), Perfluoralkoxyethylenen (PFA), Polyestern, wie Polyethylenterephthalat (PET) oder Polyethylennaphthalat (PEN), Polyimiden, insbesondere Polyetherimid, Polyethern, Polymethylmethacrylaten, Cyclo-Olefin-Polymeren, Cyclo-Olefin-Copolymeren (COC), Polyolefinen, wie Polypropylen, und Mischungen dieser Polymere umfassen oder daraus ausgebildet sein. Derartige Polymere können eine eingebrachte Polarisierung vorteilhafterweise über lange Zeit halten.

Im Rahmen einer weiteren Ausführungsform der Erfindung kann im fertig gestellten elektromechanischen Wandler die Trägerschicht eine Schichtdicke von ≥ 6 µm bis ≤ 125 µm bevorzugt von ≥ 10 µm bis ≤ 100 µm, beispielsweise ≥15 µm bis ≤ 75 µm aufweisen, und/oder die Elektretschicht eine Schichtdicke von ≥ 6 µm bis ≤ 125 µm, bevorzugt von ≥ 10 µm bis ≤ 100 µm, beispielsweise ≥ 15 µm bis ≤ 75 µm aufweisen, und/oder das Polymerschicht-Basiselement, umfassend die Trägerschicht und die Elektretschicht, eine Gesamtschichtdicke von ≥ 20 µm bis ≤ 250 µm, bevorzugt von ≥ 30 µm bis ≤ 150 µm, beispielsweise ≥ 50 µm bis ≤ 100 µm aufweisen.

In einer anderen Ausgestaltung kann die Schichtdicke der Elektretschicht relativ zur Schichtdicke der Trägerschicht dünner ausgeführt sein. Die Trägerschicht kann dabei zusätzlich aus billigerem Material hergestellt sein. Gegenüber einer einzelnen freitragenden Elektretschicht ohne Trägerschicht ist es erfindungsgemäß darüber hinaus möglich, die erfindungsgemäße Elektretschichten jeweils dünner auszuführen als in einer Ausgestaltung ohne Trägerschicht, da die notwendige Stabilität durch die Trägerschicht verliehen wird. Daher kann erfindungsgemäß die Elektretschicht deutlich Material-sparender ausgeführt sein. Hierdurch kann eine kostengünstigere Herstellbarkeit bei gleichbleibend guten oder sogar verbesserten elektromechanischen und mechanischen Eigenschaften des resultierenden elektromechanischen Wandlers bereitgestellt werden.

In einer anderen Ausgestaltung der Erfindung kann das zweite Polymerschicht-Element mindestens eine erste Aussparungen umfassende Polymerschicht und eine durchgehende Polymerschicht, das heißt ohne Aussparungen oder Hohlräume innerhalb dieser Schicht, umfassen. Mit anderen Worten wird erfindungsgemäß damit ein Polymerschichtverbund als Sandwichaufbau aus mindestens einem Polymerschicht-Basiselement, einer durchgehenden Polymerschicht und einer dazwischen angeordneten Aussparungen umfassenden Polymerschicht bereitgestellt. Diese Aussparungen umfassende Polymerschicht kann der gesamten Anordnung Flexibilität verleihen und sie entlang ihrer Dicke weicher machen. Hierdurch kann die piezoelektrische Konstante d₃₃ und damit die Sensitivität des elektromechanischen Wandlers erhöht werden.

In Rahmen einer weiteren Ausführungsform der Erfindung kann das zweite Polymerschicht-Element mindestens ein zweites Polymerschicht-Basiselement, umfassend eine Trägerschicht mit einer Erweichungstemperatur Tg_{A} und eine mit dieser flächig verbundene Elektretschicht mit einer Erweichungstemperatur Tg_{E}, wobei Tg_{A} > Tg_{E}, umfassen oder als solches ausgebildet sein. Mit anderen Worten können erfindungsgemäß beispielsweise zwei Polymerschicht-Basiselemente miteinander einen Polymerverbund mit darin ausgebildeten Hohlräumen bilden. Vorzugsweise sind dabei jeweils die Elektretschichten direkt miteinander verbunden.

Es ist erfindungsgemäß dabei im Rahmen dieser Ausgestaltung möglich, dass zwei gleiche Polymerschicht-Basiselemente miteinander einen Polymerverbund bilden. Die entsprechenden Polymerschichten bestehen in diesem Fall aus jeweils dem gleichen polymeren Material. So sind beispielsweise die Elektretschichten beider Basiselemente aus dem gleichen Material ausgebildet. Dies gilt in dieser Ausführungsform gleichermaßen für die Trägerschichten. Sind, wie erfindungsgemäß bevorzugt, die Elektretschichten zueinander gerichtet, so kann sich hierdurch vorteilhafterweise eine besonders gute Verbindbarkeit der Schichten und damit eine verbesserte mechanische Stabilität der Verbindung ergeben.

Gleichermaßen ist erfindungsgemäß umfasst, dass zwei unterschiedliche mit unterschiedlichen Polymerschichten, also Träger und/oder Elektretschichten, aufgebaute Polymerschicht-Basiselemente miteinander einen Polymerschichtverbund bilden. Es können in den beiden Basiselementen zum Beispiel die gleichen Trägerschichten, jedoch unterschiedliche Elektretschichten mit gleichen oder unterschiedlichen Erweichungstemperaturen Tg_{E} eingesetzt werden oder umgekehrt. Hierdurch ergibt sich erfindungsgemäß vorteilhafterweise eine gute Einstellbarkeit der benötigten und gewünschten Eigenschaften, beispielsweise im Hinblick auf spezielle Anwendungen des resultierenden elektromechanischen Wandlers. Erfindungsgemäß kann beispielsweise das erste Basiselement eine Elektretschicht aufweisen, welche besonders gut positive Ladungen speichern kann, während das zweite Basiselement eine Elektretschicht aufweisen kann, welche besonders gut zur Speicherung negativer Ladungen geeignet ist und umgekehrt. Hierdurch können demgemäß die elektrischen Eigenschaften des resultierenden elektromechanischen Wandlers optimiert werden.

Im Rahmen einer alternativen Ausführungsform kann als erfindungsgemäßer Polymerschichtverbund zum Beispiel auch eine Sandwich-Anordnung aus zwei Polymerschicht-Basiselementen mit einer dazwischen angeordneten Aussparungen umfassenden Polymerschicht bereitgestellt werden. Das zweite Polymerschicht-Element wird mit anderen Worten aus einer Aussparungen umfassenden Polymerschicht und einem zweiten Basiselement gebildet. Hierbei sind vorzugsweise jeweils die Elektretschichten mit der mittleren Aussparungen umfassenden Polymerschicht verbunden. Die Aussparungen sind demgemäß dann unter Ausbildung von Hohlräumen, bevorzugt durch die Elektretschichten, verschlossen. Die Trägerschichten bilden damit die von der Aussparungen umfassenden Schicht abgewandten Seiten des Polymerschicht-Basiselements in einem solchen Polymerschichtverbund. Auch in dieser Ausführungsform ist es möglich, dass die Basiselemente gleich oder unterschiedlich ausgestaltet sind.

Die Aussparungen umfassende Polymerschicht kann beispielsweise ein thermoplastisches Elastomer, wie ein thermoplastisches Polyurethan oder einen thermoplastischen Polyester, umfassen oder daraus ausgebildet sein. Diese Materialien sind vorteilhafterweise besonders geeignet, einen Polungsprozess in den Hohlräumen zu ermöglichen und die nach dem Aufladungsprozess in den Polymerfilmen gebildeten Ladungsschichten zu separieren, beispielsweise eine geringe elektrische Leitfähigkeit aufweisen. Hierdurch kann der gesamten Anordnung eine verbesserte Flexibilität verliehen werden. Darüber hinaus kann der Polymerschichtverbund in seiner Weichheit eingestellt werden. Hierdurch kann die piezoelektrische Konstante d₃₃ und damit die Sensitivität des elektromechanischen Wandlers nochmals erhöht werden.

Im Rahmen einer weiteren Ausgestaltung der Erfindung kann die Aussparungen umfassende Polymerschicht eine Erweichungstemperatur Tg_{B} aufweisen, die niedriger ist, als die jeweiligen Erweichungstemperaturen der benachbarten Polymerschichten des Basiselementes, beispielsweise der jeweiligen Erweichungstemperatur Tg_{E} der Elektretschichten, so dass diese mittlere Aussparungen umfassende Schicht zusätzlich als Klebeschicht zur Verbindung, beispielsweise mit den Elektretschichten, dienen kann.

Im Rahmen einer weiteren Ausführungsform des erfindungsgemäßen elektromechanischen Wandlers kann die erste Aussparungen umfassende Polymerschicht eine Schichtdicke von ≥ 10 µm bis ≤ 250 µm haben. Insbesondere kann die erste Aussparungen umfassende Polymerschicht eine Schichtdicke von ≥ 50 µm bis ≤ 150 µm, bevorzugt von ≥ 75 µm bis ≤ 100 µm aufweisen.

Die Aussparungen der Aussparungen umfassenden Polymerschicht können erfindungsgemäß in gleichen oder in unterschiedlichen Formen ausgebildet sein. In einer Ausführungsform des erfindungsgemäßen elektromechanischen Wandlers sind dabei zumindest ein Teil der Aussparungen in Formen ausgebildet, welche keine kreisförmige Querschnittsfläche aufweisen.

Durch eine Kombination aus in unterschiedlichen Formen ausgebildeten Aussparungen kann vorteilhafterweise zum einen das Gesamthohlraumvolumen der resultierenden Hohlräume maximiert werden und zum anderen die elektromechanischen, insbesondere piezoelektrischen, Eigenschaften des elektromechanischen Wandlers gegebenenfalls an eine bestimmte Anwendung, angepasst werden.

Die Aussparungen können in den Aussparungen umfassenden Polymerschichten des elektromechanischen Wandlers homogen oder heterogen verteilt ausgebildet sein. Insbesondere können die Aussparungen in der ersten Aussparungen umfassenden Polymerschicht homogen verteilt ausgebildet sein. In Abhängigkeit vom Anwendungsbereich des herzustellenden elektromechanischen Wandlers kann es jedoch auch vorteilhaft sein, die Aussparungen in einer Aussparungen umfassenden Polymerschicht gezielt ortsaufgelöst heterogen verteilt auszubilden.

Die Aussparungen der Aussparungen umfassenden Polymerschicht sind durchgängig, insbesondere in Richtung auf die durchgehenden Polymerschichten, insbesondere Elektretschichten der Polymerschicht-Basiselemente, durch die Aussparungen umfassende Polymerschicht ausgebildet. Die mindestens erste Aussparungen umfassende Polymerschicht kann eine Vielzahl an in einer ersten Form ausgebildeten Aussparungen und eine Vielzahl an in einer zweiten Form ausgebildeten Aussparungen und gegebenenfalls eine Vielzahl an in einer dritten Form ausgebildeten Aussparungen, et cetera, aufweisen.

Im Rahmen der vorliegenden Erfindung können die Aussparungen zum Beispiel teilweise oder vollständig in Formen ausgebildet sein, welche eine Querschnittsfläche ausgewählt aus der Gruppe bestehend aus im Wesentlichen runden, beispielsweise kreisförmigen, elliptischen oder ovalen, polygonen, beispielsweise dreieckigen, rechteckigen, trapezförmigen, rautenförmigen, fünfeckigen, sechseckigen, insbesondere wabenförmigen, kreuzförmigen, sternförmigen und teilweise runden und teilweise polygonen, beispielsweise S-förmigen, Querschnittsflächen, aufweisen. Die Aussparungen der Aussparungen aufweisenden Schichten können beispielsweise auch eine wabenförmige Querschnittsfläche aufweisen, beziehungsweise sind wabenförmig ausgebildet und/oder angeordnet. Eine wabenförmig Ausbildung und Anordnung der Aussparungen hat zum einen ein sehr großes Gesamthohlraumvolumen zur Folge. Zum anderen kann mit einer wabenförmigen Ausbildung und Anordnung der Aussparungen eine besonders hohe mechanische Stabilität erzielt werden.

Die Größe der Querschnittsflächen kann bei allen Aussparungen der Aussparungen umfassenden Polymerschicht gleich oder unterschiedlich sein. Die Aussparungen und die aus den Aussparungen gebildeten Hohlräume können in Formen mit einer eher geringen Fläche, wie Linien, beispielsweise gebogene oder gerade, einzelne oder gekreuzte Linien, beziehungsweise Umfangslinien von geometrischen Figuren, etwa einer Kreislinie oder einer Umfangslinie eines Kreuzes, oder als Strukturen mit einer größeren Fläche, wie Rechtecke, Kreise, Kreuze, et cetera, ausgebildet werden. Die Form und Dimensionierung der Hohlräume wird vorzugsweise derart eingestellt, dass sich die erste und zweite durchgehende Polymerschicht, insbesondere Polymer-folien, senkrecht zu deren Schichtverlauf innerhalb des Hohlraums nicht berühren können und/oder dass das nach Fertigstellung des elektromechanischen Wandlers resultierende Gesamthohlraumvolumen möglichst groß ist. Mit anderen Worten sollen sich insbesondere die durch eine Polung auf die inneren Oberflächen der Hohlräume aufgebrachten positiven und negativen Ladungen nicht berühren können.

In einer anderen Ausgestaltung des erfindungsgemäßen elektromechanischen Wandlers kann das Polymerschicht-Basiselement und/oder das zweite Polymerschicht-Element zum Zweck der Ausbildung von Hohlräumen im Polymerschichtverbund unter Ausbildung eines Höhenprofils mit Erhebungen und/oder Vertiefungen strukturiert, insbesondere dreidimensional geformt, ausgestaltet sein. Durch die mögliche verschiedene Ausbildung von Hohlräumen ist es möglich, Resonanzfrequenz und Piezoaktivität, und insbesondere die piezoelektrische Konstante d33, auf eine jeweilige Anwendung variabel einzustellen. Vorteilhafterweise können mit den erfindungsgemäß hergestellten Polymerschichtverbund-Systemen hohe und gleichmäßige piezoelektrische Koeffizienten auch für größere Flächen erzielt werden. Dies erschließt diesen elektromechanischen Wandlern grundsätzlich zahlreiche Anwendungen.

Ein elektromechanischer Wandler gemäß der Erfindung kann vorzugsweise weiterhin zwei Elektroden, insbesondere Elektrodenschichten umfassen, wobei eine Elektrode die Trägerschicht des Polymerschicht-Basiselements und die andere Elektrode das zweite Polymerschicht-Element jeweils auf der dem Polymerschicht-Basiselement abgewandten Oberflächenseite kontaktiert.

Ein erfindungsgemäßer elektromechanischer Wandler kann auch zwei oder mehr aufeinander gestapelte Polymerschichtverbunde mit darin ausgebildeten Hohlräumen umfassen, welche jeweils ein Polymerschicht-Basiselement und ein zweites Polymerschicht-Element aufweisen. Mit anderen Worten kann aus zwei oder mehr erfindungsgemäßen Polymerverbunden als Einzel-Anordnung, die gegebenenfalls bereits mit Elektroden versehen und/oder mit entgegen gesetzten elektrischen Ladungen gepolt sind, ein Stack gebildet werden.

Beispielsweise können die in einem Stack übereinander angeordneten Einzel-Polymerschichtverbunde Sandwich-Anordnungen sein, wobei das zweite Polymerschicht-Element aus einer Aussparungen umfassenden Polymerschicht und einem zweiten Polymerschicht-Basiselement gebildet wird und wobei die Aussparungen umfassende Polymerschicht zwischen den Elektretschichten des ersten und des zweiten Polymerschicht-Basiselements angeordnet ist. Die Aussparungen der Aussparungen umfassenden Polymerschicht werden auf einer Seite durch die Elektretschicht des ersten Polymerschicht-Basiselements und auf der anderen Seite durch die Elektretschicht des zweiten Polymerschicht-Basiselements unter Ausbildung von Hohlräumen verschlossen. Dabei können die Trägerschicht eines ersten Polymerschichtverbunds und eine Trägerschicht des zweiten Polymerschichtverbunds in einem Stack jeweils eine Elektrode kontaktieren. Vorzugsweise weisen dabei zwei benachbarte Polymerschichten unterschiedlicher Einzel-Anordnungen die gleiche Ladungspolarisation auf. Insbesondere können dabei zwei benachbarte Polymerschichten, beispielsweise Trägerschichten, unterschiedlicher Einzel-Anordnungen die gleiche Elektrode kontaktieren.

Die verschiedenen vorstehend beschriebenen Ausführungsformen können erfindungsgemäß gegebenenfalls in Kombination miteinander realisiert werden. Hinsichtlich weiterer Merkmale eines erfindungsgemäßen elektromechanischen Wandlers wird hiermit explizit auf die Erläuterungen im Zusammenhang mit dem erfindungsgemäßen Verfahren und der erfindungsgemäßen Verwendung verwiesen.

Die Erfindung betrifft weiterhin ein Verfahren zur Herstellung eines elektromechanischen Wandlers, insbesondere eines elektromechanischen Wandlers gemäß den vorstehend beschriebenen verschiedenen Ausführungsformen allein oder in Kombination miteinander.

Das erfindungsgemäße Verfahren zur Herstellung eines elektromechanischen Wandlers mindestens umfassend einen Polymerschichtverbund mit darin ausgebildeten Hohlräumen, umfasst die Schritte:
A) Bereitstellen eines Polymerschicht-Basiselements, umfassend eine Trägerschicht mit einer Erweichungstemperatur Tg_{A} und eine mit dieser flächig verbundene Elektretschicht mit einer Erweichungstemperatur Tg_{E}, wobei Tg_{A} > Tg_{E} ist,
B) Bereitstellen eines zweiten Polymerschicht-Elements,
C) Anordnen des Polymerschicht-Basiselements auf dem zweiten Polymerschicht-Element, wobei die Elektretschicht zum zweiten Polymerschichtelement hin gerichtet ist; und
D) Verbinden des Polymerschicht-Basiselements mit dem zweiten Polymerschicht-Element zu einem Polymerschichtverbund mit darin ausgebildeten Hohlräumen mittels Laminieren, wobei die gewählte Laminier-Temperatur T_{L} niedriger ist als die Erweichungstemperatur Tg_{A} und größer oder gleich der ErweichungstemperaturTg_{E} ist.

Das erfindungsgemäße Verfahren ist kostengünstig und einfach durchzuführen, da mit geringen Anpassungen auf etablierte Verfahrensschritte zurückgegriffen werden kann. Überraschenderweise können nach einem Verfahren gemäß der Erfindung mechanisch besonders stabile elektromechanische Wandler mit guten piezoelektrischen Eigenschaften erhalten werden. Vorteilhafterweise erleichtert die erfindungsgemäße Auswahl der Polymerschichten, insbesondere der Elektretschicht im Polymerschicht-Basiselement mit einer im Vergleich zur Trägerschicht niedrigeren Erweichungstemperatur Tg_{E}, die Laminierung des Polymerschichtverbunds und ermöglicht eine besonders gute Verbindung der Polymerschichten zueinander.

Die Laminiertemperatur wird bevorzugt derart gewählt, dass sie nahe der Erweichungstemperatur Tg_{E} der Elektretschicht liegt. Die Temperaturdifferenz zwischen der Laminier-Temperatur T_{L} und der Erweichungstemperatur Tg_{E} der Elektretschicht ΔT (T_{L},T_{E}) kann dabei weniger als 10 °C, bevorzugt weniger als 5 °C, betragen. Erfindungsgemäß gilt dabei für die Laminiertemperatur T_{L} < Tg_{A} und T_{L} ≥ Tg_{E}.

In einer erfindungsgemäßen Verfahrensvariante kann in Schritt A) die Bereitstellung des Polymerschicht-Basiselements, umfassend eine Trägerschicht und eine mit dieser flächig verbundene Elektretschicht, durch Coextrusion oder durch Solvent-Cast-Technik erfolgen. Diese grundsätzlich etablierten Verfahren der Filmherstellung sind leicht erfindungsgemäß einzusetzen und zudem vorteilhafterweise automatisierbar.

Im Rahmen einer anderen Ausgestaltung des Verfahrens nach der Erfindung kann Schritt A) und/oder Schritt B) die Strukturierung und/oder die dreidimensionale Formung des Polymerschicht-Basiselements und/oder des zweiten Polymerschichtelements zur Ausbildung eines Höhenprofils, also zur Ausbildung von Erhebungen und Vertiefungen, umfassen. Dies kann beispielsweise durch einen Prägeprozess erfolgen. Gleichermaßen bevorzugt kann der Prägeprozess unter Verwendung einer strukturierten Walze oder mittels eines Prägestempels erfolgen. Sowohl bei Einsatz einer strukturierten Walze als auch bei eingesetztem strukturiertem Prägestempel kann jeweils ein Höhenprofil auf die Polymerschichten übertragen werden. Es ist dabei auch möglich, auf der Oberfläche des Prägewerkzeugs, also der Walze oder des Prägestempels, Positiv- oder Negativformen aufzubringen und/oder die Strukturierung dreidimensional auf das Polymerschicht-Basiselement und/oder das zweite Polymerschicht-Element oder nur auf eine Oberflächenseite einer Polymerschicht, beispielsweise der Elektretschicht, zu übertragen. Die Strukturierung kann direkt nach der Extrusion der Polymerschichten oder auch als Einzelprozess, beispielsweise in einer Heißpresse, erfolgen. Erfindungsgemäß umfasst ist auch, dass die jeweiligen Polymerschicht-Elemente und/oder einzelne Polymerfolien von beiden Oberflächenseiten mit einem Prägewerkzeug bearbeitet werden können. Beispielsweise kann ein Polymerschicht-Basiselement und/oder ein zweites Polymerschicht-Element von der Ober- und der Unterseite mit jeweils einer strukturierten Walze geprägt und damit strukturiert werden.

In einer anderen alternativen Ausgestaltung des Verfahrens kann die Strukturierung der Polymerschicht-Elemente und/oder der Polymerfolien in Schritt A) oder Schritt B) durch Verformung der gegebenenfalls erwärmten Polymerschichten oder Polymerschicht-Elemente, also Basiselement oder zweites Polymerschichtelement unter Druckbeaufschlagung, beispielsweise mit Druckluft oder einem anderen Gas, in einem Formwerkzeug mit einem gegebenenfalls vortemperierten Kontureinsatz erfolgen. Beispielsweise kann ein Polymerschicht-Element auf eine Temperatur nahe der Erweichungstemperatur (Glasübergangstemperatur) mindestens einer seiner Polymerschichten, beispielsweise der Trägerschicht erwärmt und dann schlagartig durch Beaufschlagung mit Pressluft von ≥ 20 bis ≤ 300 bar verformt werden. Beispielsweise können Polycarbonatfolien (zum Beispiel Macrofol der Bayer MaterialScience AG) knapp unter die Glastemperatur auf 130-140 °C erwärmt werden. Danach können die Folien mit einem Luftdruck von 250 bar beaufschlagt und auf ein Formwerkzeug gepresst werden und können sich der Werkzeugkontur anpassen und dauerhaft verformt werden. Dies kann erfindungsgemäß auch auf zweischichtigen Polymerschicht-Basiselemente und/oder zweite Polymerschicht-Elemente übertragen werden.

Die genannten Strukturierungsvarianten haben den Vorteil, dass positionsgenau die Übertragung des jeweils gewünschten Profils auf die Polymerschichten, insbesondere Polymerfolien, ermöglicht wird. Sowohl Form als auch Dimensionierung der dann im Polymerschichtverbund ausgebildeten Hohlräume ist mit den vorstehend genannten Methoden vorteilhafterweise nahezu frei wählbar und kann in Abhängigkeit mit den gewählten Polymerschichtmaterialen und deren Eigenschaften und der jeweiligen Schichtdicken auf die gewünschten mechanischen und elektrischen Anforderungen einer gewünschten Anwendung angepasst werden. Die Kombination der Polymerschicht-Eigenschaften und der Form und Dimensionierung der ausgebildeten Hohlräume wird dabei so gewählt, dass die auf Abstand zu haltenden Folienabschnitte sich in keinem Nutzungsfall berühren können. Die genannten Strukturierungsmethoden haben weiterhin den Vorteil, dass sie automatisierbar sind und gegebenenfalls als kontinuierlicher Prozess durchgeführt werden können.

Das Verfahren kann in einer anderen Ausgestaltung weiterhin den Verfahrensschritt E): Aufladen der aus dem Verfahrensschritt D) hervorgehenden Anordnung, insbesondere der inneren Oberflächen der im Polymerschichtverbund ausgebildeten Hohlräume, mit entgegen gesetzten elektrischen Ladungen umfassen. Das Aufladen kann beispielsweise durch Triboaufladung, Elektronenstrahlbeschuss, Anlegen einer elektrischen Spannung an bereits vorhandene Elektroden oder Coronaentladung erfolgen. Insbesondere kann das Aufladen durch eine Zweielektroden-Corona-Anordnung erfolgen. Dabei kann die Nadelspannung mindestens > 20 kV, beispielsweise mindestens > 25 kV, insbesondere mindestens ≥ 30 kV, betragen. Die Aufladezeit kann dabei mindestens > 20 s, beispielsweise mindestens ≥ 30 s, insbesondere mindestens > 1 min, betragen. Eine CoronaBehandlung ist vorteilhafterweise auch großtechnisch gut einsetzbar.

Das Verfahren kann vor und/oder nach einer elektrischen Aufladung der inneren Oberflächen der im Polymerschichtverbund ausgebildeten Hohlräume in Schritt E) weiterhin den Verfahrensschritt F): Aufbringen einer Elektrode auf das Polymerschicht-Basiselement, insbesondere auf eine vorzugsweise durchgehende Trägerschicht, und einer Elektrode auf das zweite Polymerschichtelement umfassen. Im Rahmen der vorliegenden Erfindung können die Elektroden jedoch auch bereits zusammen mit dem Polymerschicht-Basiselement und/oder dem zweiten Polymerschicht-Element, insbesondere jeweils auf diesen ausgebildet, bereitgestellt werden.

Die Elektroden können mittels dem Fachmann bekannter Verfahren aufgebracht werden. Hierfür kommen beispielsweise etablierte Verfahren wie Sputtern, Sprühen, Aufdampfen, Chemical Vapor Deposition (CVD), Drucken, Rakeln, Spin-Coaten in Frage. Die Elektroden können auch in vorgefertigter Form aufgeklebt werden.

Bei den Elektrodenmaterialien kann es sich um dem Fachmann bekannte leitfähige Materialien handeln. Hierfür kommen beispielsweise Metalle, Metall-Legierungen, Halbleiter, leitfähige Oligo-oder Polymere, wie Polythiophene, Polyaniline, Polypyrrole, leitfähige Oxide oder Mischoxide, wie Indiumzinnoxid (ITO), oder mit leitfähigen Füllstoffen gefüllte Polymere in Frage. Als Füllstoffe für mit leitfähigen Füllstoffen gefüllte Polymere kommen beispielsweise Metalle, leitfähige Kohlenstoff basierende Materialien, beispielsweise Ruß, Kohlenstoffnanoröhrchen (Carbonanotubes (CNTs)), oder leitfähige Oligo- oder Polymere, in Frage. Der Füllstoffgehalt der Polymere liegt dabei vorzugsweise oberhalb der Perkolationsschwelle, welche dadurch gekennzeichnet ist, dass die leitfähigen Füllstoffe durchgehende elektrisch leitfähige Pfade ausbilden.

Die Elektroden können im Rahmen der vorliegenden Erfindung auch strukturiert sein. Eine strukturierte Elektrode kann beispielsweise als leitende Beschichtung in Streifen oder in Gitterform ausgestaltet sein. Hierdurch kann zusätzlich die Sensitivität des elektromechanischen Wandlers beeinflusst und auf bestimmte Anwendungen angepasst werden. Beispielsweise können die Elektroden derart strukturiert sein, dass der Wandler aktive und passive Bereiche aufweist. Insbesondere können die Elektroden derart strukturiert sein, dass, insbesondere im Sensor-Modus, Signale ortsaufgelöst detektiert und/oder, insbesondere im Aktuator-Modus, die aktiven Bereiche gezielt angesteuert werden können. Dies kann beispielsweise dadurch erzielt werden, dass die aktiven Bereiche mit Elektroden versehen sind, wohingegen die passiven Bereiche keine Elektroden aufweisen.

In einer anderen Ausgestaltung des erfindungsgemäßen Verfahrens können insbesondere die Schritte A) B), C), D) E) und/oder F) als kontinuierlicher Rolle-zu-Rolle Prozess durchgeführt werden. Vorteilhafterweise kann die Herstellung des elektromechanischen Wandlers also mindestens teilweise als kontinuierlicher Prozess, vorzugsweise als Rolle-zu-Rolle Prozess, durchgeführt werden. Dies ist besonders vorteilhaft für die Anwendung der Verfahren im großtechnischen und industriellen Maßstab. Die Automatisierung zumindest eines Teils der Herstellungsverfahren vereinfacht das bereitgestellte Verfahren und ermöglicht die kostengünstige Produktion der elektromechanischen, insbesondere piezoelektrischen Wandler. Erfindungsgemäß können vorteilhafterweise alle Schritte des Verfahrens einer Automatisierung zugänglich sein.

Im Rahmen einer weiteren erfindungsgemäßen Verfahrensvariante kann in einem Verfahrensschritt G) das Aufeinander Stapeln von zwei oder mehr aus den Verfahrensschritten D), E) oder F) hervorgehenden Anordnungen umfasst sein. Mit anderen Worten kann aus zwei oder mehr erfindungsgemäßen Polymerverbunden, die gegebenenfalls bereits mit Elektroden versehen und gepolt sind, vorteilhafterweise ein Stack gebildet werden.

Hinsichtlich weiterer Merkmale eines erfindungsgemäßen Verfahrens wird hiermit explizit auf die Erläuterungen im Zusammenhang mit dem erfindungsgemäßen elektromechanischen Wandler und dessen Verwendung verwiesen.

Ein weiterer Gegenstand der vorliegenden Erfindung ist die Verwendung eines erfindungsgemäßen elektromechanischen, insbesondere piezoelektrischen, Wandlers als Sensor, Generator und/oder Aktuator, beispielsweise im elektromechanischen und/oder elektroakustischen Bereich. Insbesondere können erfindungsgemäße elektromechanische Wandler im Bereich der Energiegewinnung aus mechanischen Schwingungen (Energy-Harvesting), der Akustik, des Ultraschalls, der medizinischen Diagnostik, der akustischen Mikroskopie, der mechanischen Sensorik, insbesondere Druck- Kraft-und/oder Dehnungssensorik, der Robotik und/oder der Kommunikationstechnologie, insbesondere in Lautsprechern, Schwingungswandlern, Lichtdeflektoren, Membranen, Modulatoren für Glasfaseroptik, pyroelektrischen Detektoren, Kondensatoren und Kontrollsystemen verwendet werden.

Hinsichtlich weiterer Merkmale einer erfindungsgemäßen Verwendung wird hiermit explizit auf die Erläuterungen im Zusammenhang mit dem erfindungsgemäßen Verfahren und dem erfindungsgemäßen elektromechanischen Wandler verwiesen.

Die erfindungsgemäße Herstellung und der Aufbau eines erfindungsgemäßen elektromechanischen, beispielsweise piezoelektrischen, Wandlers wird anhand der Figuren, der folgenden

Figurenbeschreibung und der folgenden Versuchsbeschreibungen näher erläutert. Dabei ist zu beachten, dass die Zeichnungen und die Versuchsbeschreibungen nur einen beschreibenden Charakter haben und nicht dazu gedacht sind, die Erfindung in irgendeiner Form einzuschränken.

Es zeigen:
- Fig. 1: einen schematischen Querschnitt durch ein Polymerschicht-Basiselement;
- Fig. 2: einen schematischen Querschnitt durch eine Ausführungsform eines zweiten Polymerschicht-Elements;
- Fig. 3a: einen schematischen Querschnitt durch einen Polymerschichtverbund als Sandwichanordnung mit zwei Polymerschicht-Basiselementen und einer dazwischen angeordneten Aussparungen umfassenden Polymerschicht;
- Fig. 3b: einen schematischen Querschnitt durch die in Fig. 3a gezeigte Anordnung nach dem Aufladungsprozess;
- Fig. 3c: einen schematischen Querschnitt durch die in Fig. 3b gezeigte Anordnung nach dem Aufladungsprozess und nach dem Anbringen von Elektroden;
- Fig. 4: einen schematischen Querschnitt durch einen elektromechanischen Wandler umfassend ein dreidimensional strukturiertes Basiselement verbunden mit einem nicht strukturierten Basiselement.

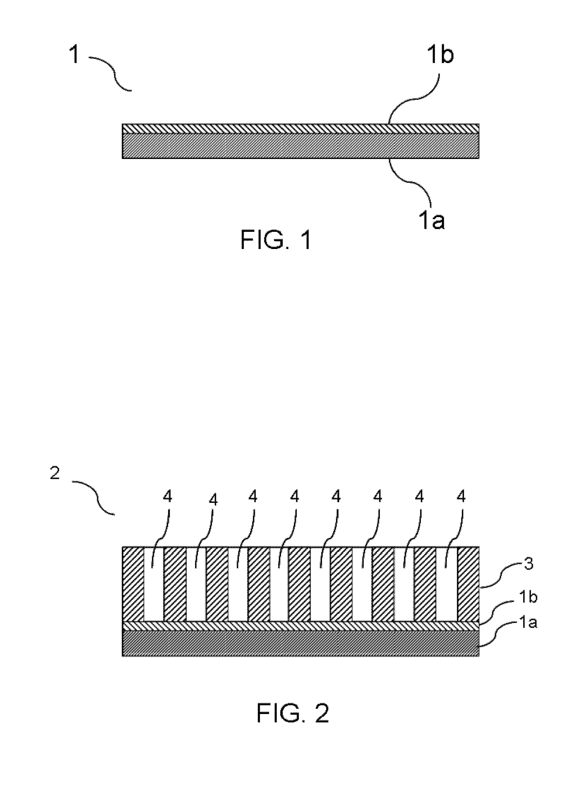

Figur 1 zeigt einen schematischen Querschnitt durch ein Polymerschicht-Basiselement 1, umfassend eine Trägerschicht 1a mit einer Erweichungstemperatur Tg_{A} und eine damit flächig verbundene Elektretschicht 1b mit einer Erweichungstemperatur Tg_{E}. Figur 1 veranschaulicht, dass das Polymerschicht-Basiselement 1 ein zweischichtiges Polymerelement ist, wobei die Polymerschichten, also die Trägerschicht 1a und die Elektretschicht 1b, vorzugsweise durchgehend, dass heißt im Wesentlichen ohne Aussparungen oder Gaseinschlüsse, ausgebildet sind. Die Erweichungstemperatur Tg_{E} der Elektretschicht 1b ist erfindungsgemäß niedriger als die Erweichungstemperatur Tg_{A} der Trägerschicht 1a. Das polymere Material der Trägerschicht 1a kann damit für die thermische und mechanische Stabilität sorgen, während die Elektretschicht 1b derart ausgestaltet sein kann, dass sie zum einen vorteilhaft als Klebeschicht zu einem weiteren Polymerschicht-Element dienen und zum anderen gute Ladungsspeichereigenschaften bereitstellen kann. Durch dieses erfindungsgemäße Zweischicht-Basiselement 1 können also vorteilhafte Eigenschaften miteinander kombiniert in einen Polymerverbund, insbesondere einen piezoelektrischen Wandler eingebracht werden.

Figur 2 zeigt einen schematischen Querschnitt durch eine Ausführungsform eines zweiten Polymerschicht-Elements 2.Dieses Polymerschicht-Element 2 bildet einen Polymerschichtverbund aus einem Polymerschicht-Basiselement 1 und einer damit verbundenen Polymerschicht 3, welche Aussparungen 4 umfasst. Figur 2 verdeutlicht, dass das Polymerschicht-Basiselement 1 in dieser Ausgestaltung des zweiten Polymerschicht-Elements 2 mit seiner Elektretschicht 1b mit der Aussparungen 4 umfassenden Polymerschicht 3 verbunden ist.

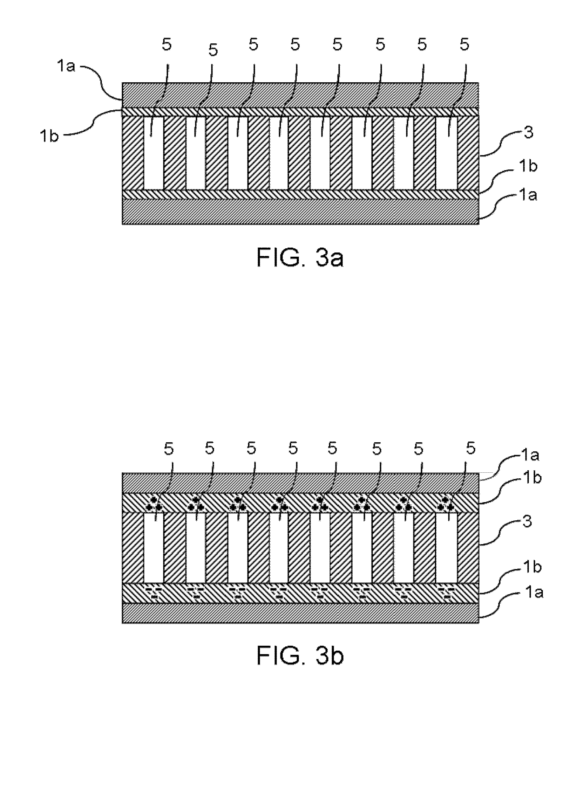

Figur 3a zeigt einen schematischen Querschnitt durch einen Polymerschichtverbund als Sandwichanordnung mit zwei Polymerschicht-Basiselementen 1 und einer dazwischen angeordneten Aussparungen 4 umfassenden Polymerschicht. Mit anderen Worten umfasst das erfindungsgemäße zweite Polymerschicht-Element 2 in dieser Ausführungsform eine Aussparungen 4 umfassende Polymerschicht 3 und ein damit verbundenes zweites Polymerschicht-Basiselement 1. Figur 3a verdeutlicht, dass beide Polymerschicht-Basiselemente 1 im Polymerschichtverbund mit ihrer Elektretschicht 1b mit der Aussparungen 4 umfassenden Polymerschicht 3 verbunden sind. Die Aussparungen 4 der Polymerschicht 3 sind hierbei durch die Elektretschicht 1b des ersten Basiselements 1 auf der einen Seite und durch die Elektretschicht 1b des zweiten Basiselements 1 auf der anderen Seite unter Ausbildung von Hohlräumen 5 verschlossen.

Figur 3b zeigt einen schematischen Querschnitt durch die in Figur 3a gezeigte Anordnung nach einer Polung gemäß Schritt E) des erfindungsgemäßen Verfahrens. Die Figur 3b veranschaulicht, dass die negativen Ladungen auf der ersten durchgehenden Elektretschicht 1b und die positiven Ladungen auf der zweiten durchgehenden Elektretschicht 1b voneinander getrennt und lokalisiert sind. Da die Elektretschichten 1b erfindungsgemäß nach ihren guten Ladungsspeichereigenschaften ausgewählt werden können, können hierdurch besonders gute piezoelektrische Eigenschaften der resultierenden elektromechanischen Wandler erzielt werden. Eine Optimierung kann in diesem Zusammenhang dadurch erzielt werden, dass unterschiedliche Materialien für die beiden Elektretschichten 1b verwendet werden und die eine ein besonders guter Ladungsspeicher für positive Ladungen und die andere entsprechend ein besonders guter Ladungsspeicher für negative Ladungen ist.

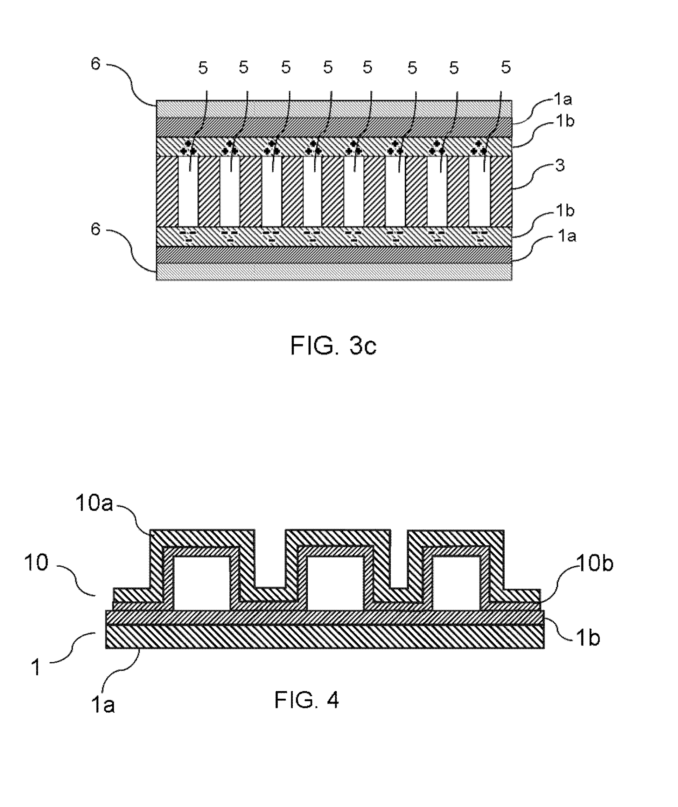

Figur 3c zeigt einen schematischen Querschnitt durch die in Figur 3a gezeigte Anordnung nach dem Aufladungsprozess und nach dem Anbringen von Elektroden 6. Die Trägerschichten 1 a des ersten und zweiten Basiselements 1 kontaktieren jeweils eine Elektrode 6. Die Elektroden 6 sind dabei als Elektrodenschichten jeweils auf den Oberflächenseiten der ersten und zweiten Trägerschicht 1 a ausgebildet, welche auf der der Aussparungen 4 umfassenden Polymerschicht 3 abgewandten Seite der Polymerschicht-Basiselemente 1 angeordnet sind.

Fig. 4 zeigt einen schematischen Querschnitt durch einen erfindungsgemäßen elektromechanischen Wandler, umfassend ein dreidimensional strukturiertes Basiselement 10 verbunden mit einem nicht strukturierten Basiselement 1. Figur 4 verdeutlicht, dass beide Basiselemente 1, 10 mit ihren Elektretschichten 1b, 10b zueinander gewandt, miteinander unter Ausbildung von Hohlräumen 5, vorzugsweise mittels Laminieren, verbunden sind. Die jeweiligen Trägerschichten 1 a, 10a und/oder Elektretschichten 1b, 10b der beiden Basiselemente 1, 10 können erfindungemäß sowohl aus dem gleichen Material oder aus unterschiedlichen polymeren Materialien ausgestaltet sein. Werden Elektretschichten 1b, 10b aus gleichem polymeren Material, eingesetzt kann sich eine besonders gute Verbindung der Elektretschichten 1b, 10bmiteinander ergeben. Wird dagegen bei unterschiedlichen Elektretschichten 1b, 10b für das erste strukturierte Basiselement 10 beispielsweise eine Elektretschicht 10b aus einem polymeren Material gewählt, welches besonders gut positive Ladung speichern kann und die Elektretschicht 1b des zweiten Basiselements 1 aus einem polymeren Material ausgebildet, welches dagegen negative Ladungen besonders gut speichern kann können die elektrisch Eigenschaften des resultierenden elektromechanischen Wandlers optimiert werden. Die Strukturierung des ersten Basiselements 10 kann beispielsweise durch eine Prägeprozess erzielt werden.

### Beispiel 1

### Herstellung eines piezoelektrischen Wandlers

Für ein erstes und ein zweites durchgehende Polymerschicht-Basiselement mit einer Gesamtdicke von 60 µm wurde ein Coextrudat aus dem jeweils gleichen Polycarbonat APEC als Trägerschicht mit einer Erweichungstemperatur Tg_{A} = 180 °C und einer Dicke von 50 µm und jeweils dem gleichen Polycarbonat Makrolon® 3108 als Elektretschicht mit einer Erweichungstemperatur Tg_{E} = 150 °C und einer Dicke von 10µm hergestellt. Das erste Polymerschicht-Basiselement wurde durch eine Walzenprägung unter Ausbildung eines Höhenprofils dreidimensional strukturiert während das zweite Basiselement, als zweites Polymerschicht-Element, eben und unstrukturiert belassen wurde. Beide Basiselemente wurden mit ihren Elektretschichten zueinander gewandt miteinander, unter Ausbildung von Hohlräumen, mittels Laminieren bei 140°C verbunden, so dass ein Polymerschichtverbund entstand, wie er in Figur 3 wiedergegeben ist. Zur Aufladung der Anordnung wurde eine Coronabehandlung bei 30 kV, 60 s gewählt, die zu einer Paschen-Entladung in den ausgebildeten Hohlräumen und zu einer Ausbildung entgegen gesetzter Ladungen auf den sich gegenüberliegenden Polymerschichten führte. Wird ein Druck auf die erfindungsgemäße Anordnung ausgeübt, resultiert hieraus eine Spannung. Es wurde eine piezoelektrische Konstante d₃₃ von 70pC/N erzielt. Der Polymerschichtverbund zeigte eine überraschend gute mechanische Stabilität, eine gute Adhäsion der Polymerschichten zueinander und gute piezoelektrische Eigenschaften.

### Beispiel 2

### Herstellung einer erfindungsgemäßen Polymerschicht-Basiselements

Für die Herstellung eines Basiselements wurde ein Polycarbonatfilm APEC mit einer Erweichungstemperatur Tg_{A} = 180 °C und ein Polymerfilm aus Cycloolefin Copolymer (COC) mit einer Erweichungstemperatur Tg_{E} = 170 °C coextrudiert. Es resultierte ein Basiselement mit einer Gesamtdicke von 60 µm, wobei die Trägerschicht eine Dicke von 50 µm und die Elektretschicht einer Dicke von 10 µm aufwies. Cycloolefin Copolymer (COC) hat besonders gute Ladungsspeichereigenschaften, neigt jedoch andererseits zur Brüchigkeit, so dass normalerweise seine Anwendbarkeit limitiert ist. Dies konnte erfindungsgemäß durch den Einsatz einer Trägerschicht im Polymerschicht-Basiselement überraschend überwunden werden, so dass die hervorragenden Elektreteigenschaften des Cycloolefin Copolymers in erfindungsgemäßen elektromechanischen Wandlern kombiniert mit guten mechanischen und thermischen Eigenschaften umgesetzt werden können.

## Patentansprüche

1. Elektromechanischer Wandler mindestens umfassend einen Polymerschichtverbund mit darin ausgebildeten Hohlräumen (5),
**dadurch gekennzeichnet, dass,**
der Polymerschichtverbund mindestens
- ein Polymerschicht-Basiselement (1) umfassend eine Trägerschicht (1a) mit einer Erweichungstemperatur Tg_{A} und eine mit dieser flächig verbundene Elektretschicht (1b) mit einer Erweichungstemperatur Tg_{E}, wobei Tg_{A} > Tg_{E} ist, und
- ein zweites Polymerschicht-Element (2) umfasst, wobei
das Polymerschicht-Basiselement (1) mit seiner Elektretschicht (1b) mindestens teilweise mit dem zweiten Polymerschicht-Element (2) unter Ausbildung von Hohlräumen (5), verbunden ist.

2. Elektromechanischer Wandler nach Anspruch 1,
**dadurch gekennzeichnet, dass**
die Trägerschicht (1a) mindestens ein Polymer, ausgewählt aus der Gruppe bestehend aus Polycarbonaten und Mischungen dieser Polymere umfasst oder daraus ausgebildet ist.

3. Elektromechanischer Wandler nach Anspruch 1 oder 2,
**dadurch gekennzeichnet, dass,**
das die Elektretschicht (1b) mindestens ein Polymer, ausgewählt aus der Gruppe bestehend aus Polycarbonaten, perfluorierten oder teilfluorierten Polymeren und Co-Polymeren, wie Polytetrafluorethylen (PTFE), Fluorethylenpropylen (FEP), Perfluoralkoxyethylenen (PFA), Polyestern, wie Polyethylenterephthalat (PET) oder Polyethylennaphthalat (PEN), Polyimiden, insbesondere Polyetherimid, Polyethern, Polymethylmethacrylaten, Cyclo-Olefin-Polymeren, Cyclo-Olefin-Copolymeren (COC), Polyolefinen, wie Polypropylen, und Mischungen dieser Polymere umfasst oder daraus ausgebildet ist.

4. Elektromechanischer Wandler nach einem der Ansprüche 1 bis 3,
**dadurch gekennzeichnet, dass,**
im fertig gestellten elektromechanischen Wandler
- die Trägerschicht (1 a) eine Schichtdicke von ≥ 6 µm bis ≤ 125 µm aufweist, und/oder
- die Elektretschicht (1b) im fertig gestellten elektromechanischen Wandler eine Schichtdicke von ≥ 6 µm bis ≤ 125 µm aufweist, und/oder
- das Polymerschicht-Basiselement (1), umfassend die Trägerschicht (1a) und die Elektretschicht (1b), eine Gesamtschichtdicke von ≥ 6 µm bis ≤ 250 µm aufweist.

5. Elektromechanischer Wandler nach einem der Ansprüche 1 bis 4,
**dadurch gekennzeichnet, dass**,
im fertig gestellten elektromechanischen Wandler die Schichtdicke der Elektretschicht (1b) relativ zur Schichtdicke der Trägerschicht (1a) dünner ausgestaltet ist.

6. Elektromechanischer Wandler nach einem der Ansprüche 1 bis 5,
**dadurch gekennzeichnet, dass,**
das zweite Polymerschicht-Element (2) mindestens eine erste Aussparungen (4) umfassende Polymerschicht (3) umfasst.

7. Elektromechanischer Wandler nach einem der Ansprüche 1 bis 6,
**dadurch gekennzeichnet, dass,**
das zweite Polymerschicht-Element (2) mindestens ein zweites Polymerschicht-Basiselement (1), umfassend eine Trägerschicht (1a, 10a) mit einer Erweichungstemperatur Tg_{A} und eine mit dieser flächig verbundene Elektretschicht (1b, 10b) mit einer Erweichungstemperatur Tg_{E}, wobei Tg_{A} > Tg_{E} gilt, umfasst oder als solches ausgebildet ist.

8. Elektromechanischer Wandler nach einem der Ansprüche 1 bis 7,
**dadurch gekennzeichnet, dass,**
das Polymerschicht-Basiselement (1) und/oder das zweite Polymerschicht-Element (2) zur Ausbildung von Hohlräumen (5) im Polymerschichtverbund unter Ausbildung von Erhebungen und/oder Vertiefungen strukturiert und/oder dreidimensional geformt ausgestaltet sind.

9. Verfahren zur Herstellung eines elektromechanischen Wandlers mindestens umfassend einen Polymerschichtverbund mit darin ausgebildeten Hohlräumen (5),
**gekennzeichnet, durch**
die Schritte:
A) Bereitstellen eines Polymerschicht-Basiselements (1) umfassend eine Trägerschicht (1 a) mit einer Erweichungstemperatur Tg_{A} und eine mit dieser flächig verbundene Elektretschicht (1b) mit einer Erweichungstemperatur Tg_{E}, wobei Tg_{A} > Tg_{E} ist,
B) Bereitstellen eines zweiten Polymerschicht-Elements (2),
C) Anordnen des Polymerschicht-Basiselements (1) auf dem zweiten Polymerschicht-Element (2) wobei die Elektretschicht (1b) zum zweiten Polymerschichtelement (2) hin gerichtet ist; und
D) Verbinden des Polymerschicht-Basiselements (1) mit dem zweiten Polymerschicht-Element (2) zu einem Polymerschichtverbund mit darin ausgebildeten Hohlräumen (5) mittels Laminieren, wobei die gewählte Laminier-Temperatur T_{L} niedriger ist als die Erweichungstemperatur Tg_{A} und größer oder gleich der ErweichungstemperaturTg_{E} ist.

10. Verfahren nach Anspruch 9,
**dadurch gekennzeichnet, dass,**
die Temperaturdifferenz zwischen der Laminier-Temperatur T_{L} und der Erweichungstemperatur Tg_{E} der Elektretschicht (1b) ΔT (T_{L} ,Tg_{E}) ≤ 10 °C beträgt.

11. Verfahren nach Anspruch 9 oder 10,
**dadurch gekennzeichnet, dass,**
in Schritt A) die Bereitstellung des Polymerschicht-Basiselements (1), umfassend eine Trägerschicht (1a) und eine mit dieser flächig verbundene Elektretschicht (1b), durch Coextrusion oder durch Solvent-Cast-Technik erfolgt.

12. Verfahren nach einem der Ansprüche 9 bis 11,
**dadurch gekennzeichnet, dass,**
Schritt A) und/oder Schritt B) die Strukturierung und/oder dreidimensionale Formung des Polymerschicht-Basiselements (1) und/oder des zweiten Polymerschichtelements (2) umfasst.

13. Verfahren nach einem der Ansprüche 9 bis 12,
**dadurch gekennzeichnet, dass,**
das Verfahren als weiteren Schritt
E) die elektrische Aufladung der inneren Oberflächen der im Polymerschichtverbund
ausgebildeten Hohlräume (5) mit entgegen gesetzten elektrischen Ladungen umfasst.

14. Verfahren nach einem der Ansprüche 9 bis 13,
**dadurch gekennzeichnet, dass,**
das Verfahren vor und/oder nach einer elektrischen Aufladung der inneren Oberflächen der ausgebildeten Hohlräume (5) in Schritt E) in einem Schritt
F) die Aufbringung von Elektroden (6) auf das Polymerschicht-Basiselement (1) und/oder auf das zweite Polymerschicht-Element (2)
umfasst.

15. Verfahren nach einem der Ansprüche 9 bis 14,
**dadurch gekennzeichnet, dass,**
es als Verfahrensschritt
G) das Aufeinander Stapeln von zwei oder mehr aus den Verfahrensschritten D), E) und/oder F) hervorgehenden Anordnungen umfasst.
